# EUROPEAN PATENT APPLICATION

(11) **EP 1 729 380 A1**
(43) Date of publication of application: **06.12.2006**
(21) Application number: 06010269.6
(22) Date of filing: 18.05.2006
(51) Int. Cl.: H01S 5/02

(54) **Optical element and method for manufacturing the same**

(30) Priority: 02.06.2005 JP 2005162540
(71) Applicant: SEIKO EPSON CORPORATION, Tokyo 160-0811 (JP)
(72) Inventor: Nagawa, Michifumi, Suwa-shi, Nagano-ken 392-8502 (JP); Sato, Atsushi, Suwa-shi, Nagano-ken 392-8502 (JP)
(74) Representative: Hoffmann, Eckart

(57) **Abstract**

An optical element includes a columnar section (130) having an upper surface (132) for light emission or light incidence, an electrode (150) that is electrically connected to the upper surface (132) of the columnar section (130), and a mark (160) formed by using a common resist as a mask that is used for forming the electrode (150).

## Description

### BACKGROUND

### Technical Field

The present invention relates to optical elements and methods for manufacturing the same.

### 2. Related Art

It is important to align an optical element with an optical waveguide (e.g., an optical fiber) with high accuracy. For example, an active alignment in which a light beam is emitted from an optical surface (or a light beam is made incident upon an optical surface) of an optical element to thereby align the optical element with the waveguide is known. However, it is necessary to operate the optical element during this process, and therefore its cost is high and the process is complex. On the other hand, as described in Japanese Laid-open Patent Application JP-A-2000-77781, a passive alignment in which a semiconductor laser and an optical fiber are mounted and fixed at predetermined fixed positions to thereby form a coupled system is known.

### SUMMARY

In accordance with an advantage of some aspects of the present invention, an optical element and a method for manufacturing the same, which can realize high accuracy alignment, can be provided.
(1) An optical element in accordance with an embodiment of the invention includes a columnar section having an upper surface for light emission or light incidence, an electrode that is electrically connected to the upper surface of the columnar section, and a mark formed by using a common resist as a mask that is used for forming the electrode.
   According to the present embodiment, the mark is formed by using a common resist as a mask that is used for forming the electrode, such that the mark is disposed at an accurate position with respect to the electrode. On the other hand, the electrode is electrically connected to the upper surface of the columnar section, and the center axis of the light path is determined by the position of the electrode. In other words, in accordance with the present embodiment, the mark is disposed at an accurate position with respect to the center axis of the light path, such that an optical element that can achieve highly accurate alignment can be provided.
   It is noted that, in the present invention, the case of a layer B being provided above a specific layer A includes a case where the layer B is directly provided on the layer A, and a case where the layer B is provided over the layer A through another layer. This similarly applies to the following inventions.
(2) An optical element in accordance with another embodiment of the invention includes a columnar section having an upper surface for light emission or light incidence, an electrode that is electrically connected to the upper surface of the columnar section, and a mark containing the same material as that of the electrode.
(3) In the optical element, the electrode may be formed to surround a center section of the upper surface of the columnar section.
   By this, the center axis of the light path coincides with the center that is surrounded by the electrode.
(4) The optical element may further include a resin layer provided around the columnar section, and at least a portion of the mark may be formed in a region outside of the resin layer.
(5) In the optical element, the mark may be used as a reference to position a line in at least one of an X direction and a Y direction of a wafer when the wafer is divided along the X direction and the Y direction.
(6) In the optical element, the mark may include a section that extends along the X direction and a section that extends along the Y direction.
(7) In the optical element, the mark may be formed in an L-shape.
(8) A method for manufacturing an optical element in accordance with an embodiment of the invention includes the steps of:
   (a) forming, above a substrate, a columnar section having an upper surface for light emission or light incidence; and
   (b) forming an electrode that is electrically connected to the upper surface of the columnar section and a mark above the substrate by using a common resist as a mask.
   According to the present embodiment, the mark is formed by using a common resist as a mask that is used for forming the electrode, such that the mark can be disposed at an accurate position with respect to the electrode. On the other hand, the electrode is electrically connected to the upper surface of the columnar section, and the center axis of the light path is determined by the position of the electrode. In other words, in accordance with the present embodiment, the mark can be disposed at an accurate position with respect to the center axis of the light path, such that an optical element that can achieve highly accurate alignment can be provided.
(9) In the method for manufacturing an optical element, the step (b) may be conducted by using a lift-off method.
(10) In the method for manufacturing an optical element, the step (b) may be conducted by using an etching method.

### BRIEF DESCRIPTION OF THE DRAWINGS

- FIG. 1: is a plan view of an optical element in accordance with an embodiment of the invention.
- FIG. 2: is a cross-sectional view of the optical element in accordance with the embodiment of the invention.
- FIG. 3: is a view for describing an optical element in accordance with an embodiment of the invention.
- FIG. 4: is a view showing a step of a method for manufacturing an optical element in accordance with an embodiment of the invention.
- FIG. 5: is a view showing a step of the method for manufacturing an optical element in accordance with the embodiment of the invention.
- FIG. 6: is a view showing a step of the method for manufacturing an optical element in accordance with the embodiment of the invention.
- FIG. 7: is a view showing a step of the method for manufacturing an optical element in accordance with the embodiment of the invention.
- FIG. 8: is a view showing a step of the method for manufacturing an optical element in accordance with the embodiment of the invention.
- FIG. 9: is a view showing a step of the method for manufacturing an optical element in accordance with the embodiment of the invention.
- FIG. 10: is a view showing a step of the method for manufacturing an optical element in accordance with the embodiment of the invention.
- FIG. 11: is a view showing a step of the method for manufacturing an optical element in accordance with the embodiment of the invention.
- FIG. 12: is a view showing a step of the method for manufacturing an optical element in accordance with the embodiment of the invention.

### DESCRIPTION OF EXEMPLARY EMBODIMENTS

Preferred embodiments of the invention are described below with reference to the accompanying drawings.

### A. Optical Element

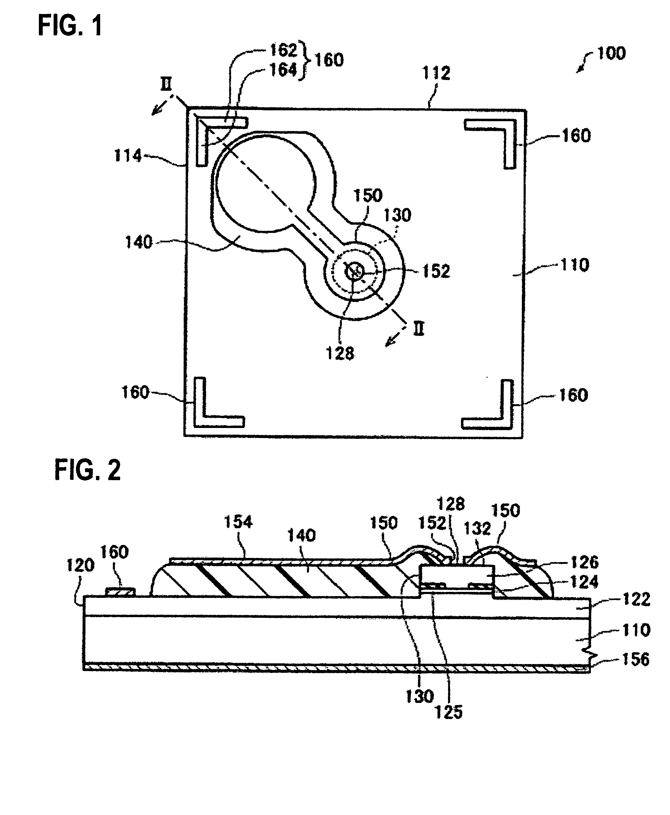

FIG. 1 is a plan view of an optical element in accordance with an embodiment of the present invention, and FIG. 2 is a cross-sectional view taken along a line II-II of FIG. 1.

The optical element 100 includes a substrate 110, an element section (a columnar section 130), a resin layer 140, an electrode 150, another electrode 156, and marks 160. In the present embodiment, an example in which the optical element 100 is a surface-emitting type device (e.g., a surface-emitting type semiconductor laser) is described. Also, an example in which the substrate 110 is a chip is described.

### (A-1) First, the substrate 110 and the element section 120 are described.

The substrate 110 is a semiconductor substrate (for example, an n-type GaAs substrate). The element section 120 is formed on the substrate 110. The substrate 110 and the element section 120 may have the same plane configuration (for example, rectangular). In the case of a surface-emitting type semiconductor laser, the element section 120 is called a resonator (a vertical resonator).

The element section 120 includes the columnar section 130. As shown in FIG. 2, the element section 120 may have a convex cross-sectional shape, and a protruded section of the convex cross-sectional shape may define the columnar section 130. The columnar section 130 may have a side surface that is vertical or a positively tapered with respect to the substrate surface. The columnar section 130 may have a plane configuration that is in a circular shape, a rectangular (square or oblong) shape or other polygonal shapes. In the example shown in FIG. 1, a single columnar section 130 is formed on a single substrate 110, but a plurality of columnar sections 130 may be formed thereon. A center section of the upper surface 132 of the columnar section 130 defines an optical surface for emission or incidence of light (laser beam) (an emission surface in the case of a surface-emitting type semiconductor laser) 128. The optical surface 128 is exposed through an opening in the resin layer 140 and the electrode 150.

The element section 120 is formed from, for example, a first mirror (a first semiconductor layer in a wider sense) 122 that is a distributed reflection type multilayer mirror of 40 pairs of alternately laminated n-type Al_{0.9} Ga_{0.1} As layers and n-type Al_{0.15} Ga_{0.85} As layers, an active layer 124 (a functional layer in a wider sense) that is composed of GaAs well layers and Al_{0.3} Ga_{0.7} As barrier layers in which the well layers include a quantum well structure composed of three layers, and a second mirror (a second semiconductor layer in a wider sense) 126 that is a distributed reflection type multilayer mirror of 25 pairs of alternately laminated p-type Al_{0.9} Ga_{0.1} As layers and p-type Al_{0.15} Ga_{0.85} As layers, which are successively laminated. It is noted that the composition of each layer and the number of layers composing the first mirror 122, the active layer 124 and the second mirror 126 may not be limited to the above. Also, the active layer 124 includes a layer in which recombinations of carriers occur, and may have a single quantum well structure or a multiple quantum well structure.

The second mirror 126 is made to be p-type by doping, for example, C, Zn or Mg, and the first mirror 122 is made to be n-type by doping, for example, Si or Se. Accordingly, a pin diode is formed by the second mirror 126, the active layer 124 in which no impurity is doped, and the first mirror 122.

A current constricting layer 125 composed of aluminum oxide as the main component is formed in a region near the active layer 124 among the layers composing the second mirror 126. The current constricting layer 125 may be formed in a ring shape. In other words, the current constricting layer 125 has a cross section defined by concentric circles when cut in a plane parallel with the optical surface 128.

The columnar section 130 refers to a semiconductor laminated body including at least the second mirror 126 (in the example shown in FIG. 2, the second mirror 126, the active layer 124 and a portion of the first mirror 122). The columnar section 130 is supported on the substrate 110.

### (A-2) Next, the resin layer 140 is described.

The resin layer 140 is formed over the substrate 110 (the element section 120). As shown in FIG. 1, the resin layer 140 is formed in a region including at least the circumference of the columnar section 130. Also, the resin layer 140 is formed as a base of the electrode 150 (the pad section 152 in particular). By this, the surface can be planarized, and patterning of the electrode would become easier. Also, by placing the resin with a low dielectric constant between the element section 120 and the electrode 150, the parasitic capacitance can be reduced. It is noted that the resin layer 140 may be formed to a thickness that is generally the same as that of the columnar section 130.

When the resin layer 140 does not have an optical transparency, the resin layer 140 is formed in a region that avoids at least the optical surface 128. In the example shown in FIG. 2, the resin layer 140 is formed to cover the side surface of the columnar section 130, cover a boundary (a corner section) between the upper surface 132 and the side surface of the columnar section 130, and extend to an end section of the upper surface 132 of the columnar section 130.

Alternatively, as a modified example, the resin layer 140 may be formed in an area that avoids the entire area of the upper surface 132 of the columnar section 130. In this case, the upper surface of the resin layer 140 and the upper surface 132 of the columnar section 130 may be made generally flush with each other such that a step difference is not generated at the boundary between the columnar section 130 and the resin layer 140.

Also, the resin layer 140 may be formed continuously along the rim (i.e., along the entire periphery) of the upper surface 132 of the columnar section 130. Also, the resin layer 140 may be smoothly sloped such that it gradually thins from the rim of the columnar section 130 toward its center, whereby disconnection of the electrode 150 can be effectively prevented.

The resin layer 140 may be formed with, for example, polyimide resin, fluororesin, acrylic resin, or epoxy resin.

### (A-3) Next, the electrode 150 and the other electrode 156 are described.

The electrode 150 is electrically connected to the upper surface 132 of the columnar section 130. For example, the electrode 150 is electrically connected to the second mirror 126 at an end section of the upper surface 132 of the columnar section 130 (in other words, in a region that avoids the optical surface 128). Also, in the example shown in FIG. 1, the electrode 150 is formed continuously along the rim (i.e., along the entire periphery) of the upper surface 132 of the columnar section 130, and its connecting area with the second mirror 126 forms a ring shape. In other words, the electrode 150 is formed in a manner to surround the center section of the upper surface 132 of the columnar section 130. A portion that is exposed through an opening section 152 of the electrode 150 defines the optical surface 128. The electrode 150 may be formed from a laminated film of layers of, for example, an alloy of Au and Zn, and Au.

The light passes through the upper surface 132 of the columnar section 130, and the center axis of the light path is determined by the position of the electrode 150. This is because an area of the formed electric field and the center axis of the emitted light (or incident light) concur with each other. For example, when the electrode 150 is formed in a manner to surround the center section of the upper surface 132 of the columnar section 130, the center axis of the light path coincides with the center of the exposed region of the electrode 150 (in other words, the optical surface 128).

The electrode 150 is formed in a manner to extend from the upper surface 132 of the columnar section 130 onto the resin layer 140, and has a pad section 154 on the resin layer 140. The pad section 154 is an external electrical connection section, and may include a bonding region for bonding a conductive material (not shown) such as a wire and a bump. When a portion of the electrode 150 that connects the pad section 154 and the columnar section 130 serves as a wiring section, the width of the pad section 154 may be made wider than the wiring section.

The other electrode 156 is electrically connected to the side of the first mirror 122, and may be formed on the back surface of the substrate 110. Alternatively, a portion of the substrate 110 (the element section 120) may be exposed through the resin layer 140, and the other electrode 156 may be connected to the exposed region. The electrode 156 may be formed from a laminated film of layers of, for example, an alloy of Au and Ge, and Au.

An electric current can be injected in the active layer 124 between the first and second mirrors 122 and 126 by the electrodes 150 and 156. It is noted that the material of the electrodes 150 and 156 is not limited to those described above, but other metals such as Ti, Ni, Au, Pt, and an alloy of at least two of the aforementioned metals can be used.

### (A-4) Next, the marks 160 are described.

The marks 160 are formed over the substrate 110 (e.g., above the element section 120 in FIG. 2). At least a portion of the marks 160 may be formed in regions outside of the resin layer 140. By this, the marks 160 can be readily formed on a flat surface of the substrate 110 (the element section 120). Alternatively, for example, when the entire surface of the substrate 110 (the element section 120) is covered by the resin layer 140, the marks 160 may be formed on the resin layer 140. Also, a portion of the mark 160 and a portion of the resin layer 140 may be overlapped each other. By this, the chip area can be effectively utilized. When a portion of the mark 160 and a portion of the resin layer 140 are overlapped each other, the mark may be formed below the resin layer 140.

The marks 160 are formed by using a common resist as a mask that is used for forming the electrode 150 (see the sections (B-3) and (B-4) to be described below). In other words, the marks 160 are formed by the same patterning step that is conducted for forming the electrode 150. By this, the marks 160 can be disposed at correct positions with respect to the electrode 150. On the other hand, the electrode 150 is electrically connected to the upper surface 132 of the columnar section 130, and the center axis of the light path is determined by the position of the electrode 150, as described above. In other words, in accordance with the present embodiment, the marks 160 are disposed at correct positions with respect to the center axis of the light path, such that an optical element that can realize highly accurate alignment can be provided.

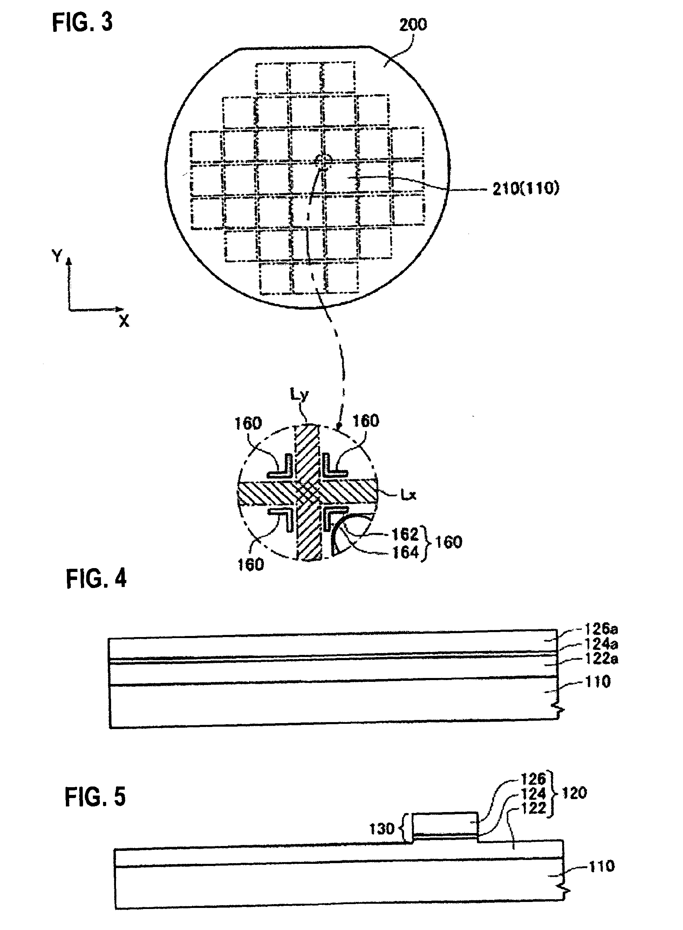

As shown in FIG. 3, when a wafer 200 is divided (for example, when scribed) along an X direction and a Y direction (i.e., a direction orthogonal to the X direction), the marks 160 can be used as a reference for positioning at least one of lines L_{X} and L_{Y} along the X direction and the Y direction. In the example shown in a partially enlarged view in FIG. 3, each of the marks 160 includes a first section 162 extending along the X direction (for example, extending in parallel with the X direction), and a second section 164 extending along the Y direction (for example, extending in parallel with the Y direction). By this, the first section 162 can be used as a reference for positioning the line L_{X} in the X direction, and the second section 164 can be used as a reference for positioning the line L_{Y} in the Y direction. More specifically, when the marks 160 are formed on each of a plurality of chip regions 210 (which corresponds to the substrate 110 after having been divided into an individual piece in the present example), the marks 160 on adjacent ones of the chip regions 210 are recognized, and the center of the line L_{X} and L_{Y} can be positioned based on the positional relations of the marks 160. Concretely, an intermediate point between the first sections 162 (or the second sections 164) of the adjacent marks 160 can be defined as a center of the line L_{X} (or the line L_{Y}).

The mark 160 is formed in a manner to be separated from the electrode 150. Alternatively, if there is no electrical problem, the mark 160 and the electrode 150 may be formed in a manner to be connected to each other. Also, a plurality of marks 160 may be formed with respect to each substrate 110, or a single mark 160 may be formed thereon. Also, the mark 160 may be formed at an end section of the substrate 110. In this case, the mark 160 may be disposed such that the interior angle of the first and second sections 162 and 164 faces the center of the substrate 110.

In the example shown in FIG. 1, the substrate 110 is in a rectangular shape, and has marks 160 formed at the four corners of the substrate 110, respectively. Alternatively, one of the four corners of the substrate 110 may be used as a marking region, and the remaining three corners may be provided with the marks 160, respectively. Alternatively, the marks 160 may be formed at two (for example, adjacent two or diagonally opposing two) of the four corners of the substrate 110, respectively.

It can be said that, as shown in FIG. 1, the mark 160 includes the first section 162 extending along one of the sides 112 of the substrate 110, and the second section 164 extending along the side 114 adjacent to the sides 112. Also, it can be said that the mark 160 is in an L-shape. In this case, the transverse and longitudinal segments of the L-shape may have the same length, or may have different lengths.

The marks 160 may be formed with a conductive material, or with an insulating material. The marks 160 may be visually recognized by a detection device such as a camera.

The marks 160 include the same material as that of the electrode 150. For example, when the electrode 150 is composed of a plurality of layers, the mark 160 may be composed of the same material as that of at least one of the layers. Also, regardless of whether the electrode 150 is composed of a plurality of layers or a single layer, the mark 160 may be composed of only the layer(s) with the same material(s) as that(those) of the electrode 150.

In the example shown in FIG. 1, the marks 160 are formed in contact with the element section 120, but the marks 160 may be formed, as a modified example, through a protection layer, such as, a silicon oxide or silicon nitride layer. Alternatively, if the marks 160 are visually recognizable from outside, the marks 160 may be covered by a protection layer such as a silicon oxide or silicon nitride layer.

By the optical element in accordance with the present embodiment, as described above, because the marks 160 are disposed at correct positions with respect to the center axis of the light path, an optical element that can realize highly accurate alignment can be provided. In other words, for example, the optical element 100 and an optical waveguide (e.g., an optical fiber) can be mechanically and highly accurately aligned with each other. By this, the optical element does not need to be operated during alignment, such that the cost can be reduced and the process can be simplified. Also, the marks 160 can be used for positioning scribe lines.

It is noted that, because the optical surface 128 of the optical element 100 is formed in a small diameter, for example, on the order of about several ten micrometers, and surrounded by the metal of the electrode 150 with a high reflectance, an optical image would be blurred and therefore alignment by directly visually inspecting the optical surface 128 is difficult. In contrast, in accordance with the present embodiment, as the marks 160 are separately provided, blurring of an optical image can be cancelled and alignment can be made easier through adjusting the size, configuration and material of the marks 160, or making the contrast thereof with respect to its base layer clearer.

(A-5) It is noted that the optical element in accordance with the present embodiment is not limited to surface-emitting type semiconductor lasers, but may also be applicable to other optical elements (for example, semiconductor emission diodes and organic LEDs), or photodetecting elements (for example, photodiodes). In the case of a photodetecting element, the optical surface 128 of the columnar section 130 defines a light incidence surface. In the case of a photodetecting element, the element has at least a photoabsorption layer (a functional layer in a wider sense). Also, in this case, semiconductor layers (which may be also referred to as contact layers) may often be provided above and below the photoabsorption layer.

It is noted that the p-type and n-type characteristics of each of the semiconductor layers described above can be interchanged. The above example is described as using AlGaAs type material, but other materials, such as, for example, GalnP type, ZnSSe type, InGaN type, AlGaN type, InGaAs type, GaInNAs type, and GaAsSb type semiconductor materials can also be used depending on the oscillation wavelength to be generated.

Also, the substrate 110 may be omitted in the embodiment described above. More specifically, after the element section 120 is formed on the substrate 110, an optical element may be manufactured by using a method that finally peels off the substrate 110 (i.e., an epitaxial lift-off method).

It is noted that the above embodiment is described as to the case where the substrate 110 is a chip, but the present embodiment includes the case where the substrate is a wafer. In this case, a plurality of chip regions are provided on the substrate, and the marks 160 described above are formed on each of the chip regions.

### B. Method for Manufacturing Optical Element

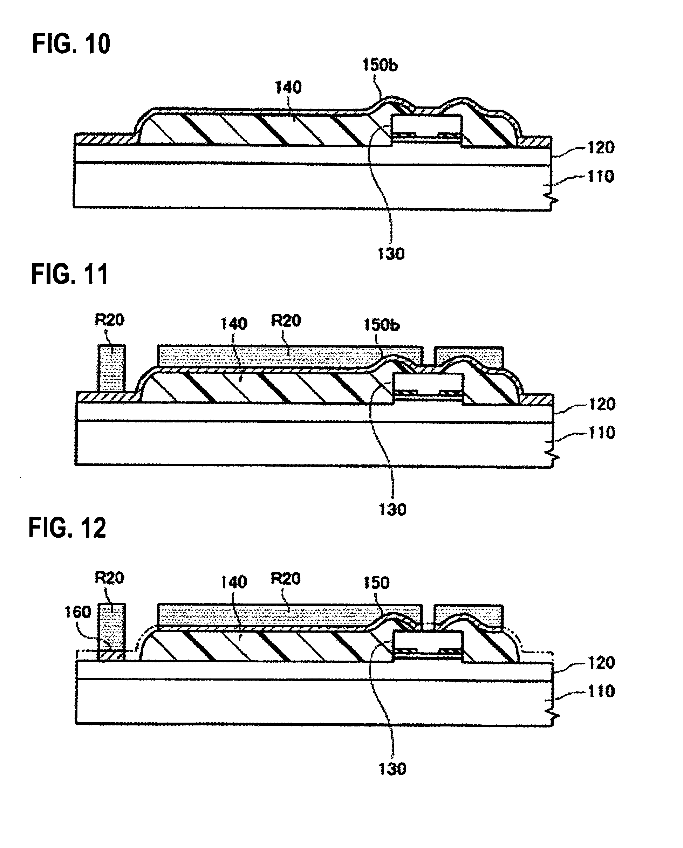

FIG. 4 through FIG. 9 are views showing a method for manufacturing an optical element in accordance with an embodiment of the invention. It is noted that FIG. 10 through FIG. 12 are views showing a modified example of the aforementioned optical element.

### (B-1) First, as shown in FIG. 4 through FIG. 6, an element section 120 including a columnar section 130 is formed on a substrate 110.

As shown in FIG. 4, on the surface of the semiconductor substrate 110 composed of n-type GaAs, a semiconductor multilayer film is formed by epitaxial growth while varying the composition. It is noted here that the semiconductor multilayer film is formed from, for example, a first mirror 122 of 40 pairs of alternately laminated n-type Al_{0.9}Ga_{0.1}As layers and n-type Al_{0.15}Ga_{0.85}As layers, an active layer 124 composed of GaAs well layers and Al_{0.3}Ga_{0.7}As barrier layers in which the well layers include a quantum well structure composed of three layers, and a second mirror 126 of 25 pairs of alternately laminated p-type Al_{0.9}Ga_{0.1}As layers and p-type Al_{0.15}Ga_{0.85}As layers.

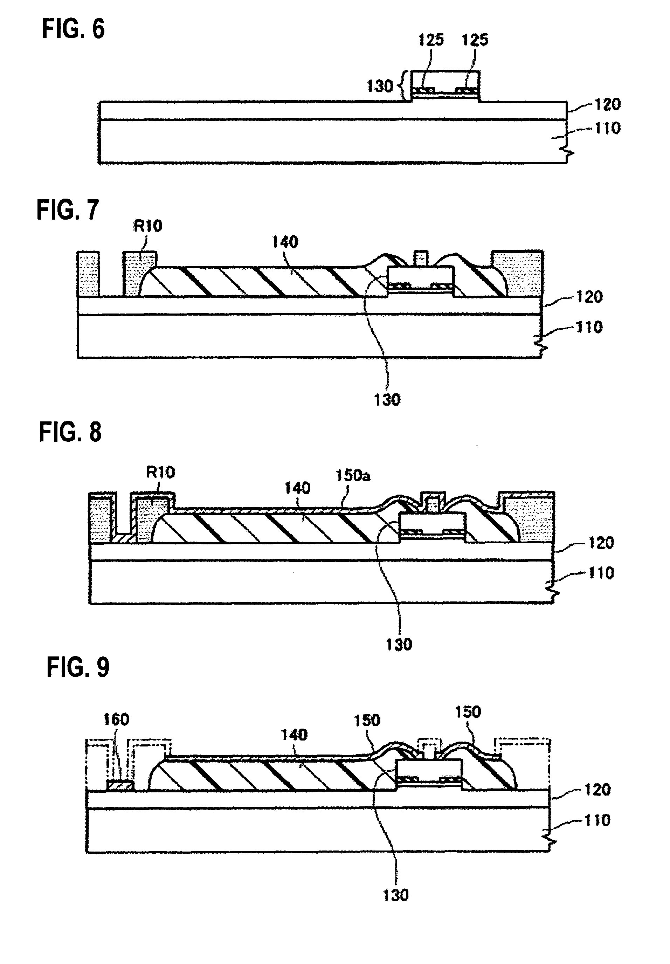

When growing the second mirror 126, at least one layer adjacent to the active layer 124 may be formed as an AlAs layer or an AlGaAs layer with an Al composition being 0.95 or higher. This layer is later oxidized and becomes a current constriction layer 125 (see FIG. 6). Also, the layer at the topmost surface of the second mirror 126 may preferably be formed to have a high carrier density, such that an ohmic contact can be readily made with an electrode 150.

The temperature at which the epitaxial growth is conducted is appropriately decided depending on the growth method, the kind of raw material, the type of the semiconductor substrate 110, and the kind, thickness and carrier density of the semiconductor multilayer film to be formed, and in general may preferably be 450°C - 800°C. Also, the time required for conducting the epitaxial growth is appropriately decided just like the temperature. Also, a metal-organic vapor phase deposition (MOVPE: Metal-Organic Vapor Phase Epitaxy) method, a MBE method (Molecular Beam Epitaxy) method or a LPE (Liquid Phase Epitaxy) method can be used as a method for the epitaxial growth.

Then, a resist layer (not shown) patterned in a predetermined shape is formed on the semiconductor multilayer film. By using the resist layer as a mask, the second mirror 126, the active layer 124 and a part of the first mirror 122 are etched by, for example, a dry etching method, thereby forming a columnar section 130, as shown in FIG. 5.

Next, by placing the semiconductor substrate 110 on which the columnar section 130 is formed in a water vapor atmosphere at about 400°C, for example, a layer having a high Al composition (a layer with an Al composition being 0.95 or higher) provided in the above-described second mirror 126 is oxidized from its side surface, thereby forming the current constriction layer 125, as shown in FIG. 6. The oxidation rate depends on the furnace temperature, the amount of water vapor that is supplied, and the Al composition and the film thickness of the layer to be oxidized. When the surface-emitting type semiconductor laser equipped with the current constricting layer 125 described above is driven, an electric current flows only in a portion where the current constricting layer 125 is not formed (i.e., a portion that has not been oxidized). Accordingly, the current density can be controlled by controlling the forming region of the current constricting layer 125 in the process of forming the current constricting layer 125 by oxidation.

### (B-2) Next, a resin layer 140 is formed (see FIG. 7).

The resin layer 140 may be formed through providing a precursor layer (not shown) to cover the entire surface of the element section 120, and then patterning the precursor layer. The precursor layer may be provided by, for example, a spin coat method, a dipping method, a spray coat method or the like. Alternatively, the precursor layer may be directly formed in a predetermined pattern configuration by a droplet discharge method or the like. Then, the precursor layer is heated to, for example, about 350 °C, to be cured and contracted, thereby forming the resin layer 140.

### (B-3) Next, as shown in FIG. 7 through FIG. 9, an electrode 150 and marks 160 are formed by using a common resist R10 as a mask. The electrode 150 and the marks 160 may be formed from the same material (for example, a metal layer of a p-type electrode).

The electrode 150 and the marks 160 may be formed by, for example, a lift-off method.

First, as shown in FIG. 7, the resist R10 is formed by patterning a resist layer in a predetermined configuration. A metal layer 150a in regions where the resist R10 is provided is finally peeled off and removed. Accordingly, the plane configuration of the resist R10 after patterning defines a reverse configuration of the forming region of the electrode 150 and the marks 160.

Next, as shown in FIG. 8, a metal layer 150a is formed on the resist R10 and on the opening regions. The metal layer 150a may be formed by a vapor deposition method, a sputter method or the like. The metal layer 150a may be formed in a single layer or a plurality of layers. In the case of a plurality of layers, the layers can be formed from different materials, respectively. Before forming the metal layer 150a, film forming regions may be washed by a plasma treatment or the like if necessary.

Then, as shown in FIG. 9, the resist R10 and portions of the metal layer 150a on the resist R10 are peeled and removed. By this, the metal layer 150a remains only in opening regions where the resist R10 is not formed, and these portions become to be the electrode 150 or the marks 160.

By this, as described above, the marks 160 are formed by using the same resist R10 as a mask that is used for forming the electrode 150, such that the marks 160 can be formed at correct positions with respect to the position of the electrode 150, in other words, the center axis of the light path.

It is noted that, after or during formation of the electrode 150, an anneal treatment (alloying treatment) may be conducted at high temperatures, for example, at about 350 °C. Also, another electrode 156 may be formed, for example, on the back surface of the substrate 119, and its forming method may be the same as the method used for forming the electrode 150 as described above.

### (B-4) FIG. 10 through FIG. 12 are views showing a modified example of the process for forming electrode and marks. An electrode 150 and marks 160 may be formed by using, for example, an etching method, besides the lift-off method described above.

First, as shown in FIG. 10, a metal layer 150b is formed over the entire surface of a substrate 110. The details described for the metal layer 150a may be applied to the film forming method, material and composition of the metal layer 150b.

Next, as shown in FIG. 11, a resist R20 is formed by patterning a resist layer in a predetermined configuration. Because the metal layer 150b is removed by etching at opening regions that open through the resist R20, the plane configuration of the resist R20 after patterning concurs with the forming region of the electrode 150 and the marks 160.

Then, as shown in FIG. 12, portions of the metal layer 150b provided at opening regions where the resist R20 is not formed are removed. By this, the metal layer 150b remains only in portions that are covered by the resist R20, and these portions become to be the electrode 150 and the marks 160.

According to the modified example, as described above, because the marks 160 can be formed at correct positions with respect to the center axis of the light path, a method for manufacturing an optical element that can realize highly accurate alignment can be provided.

The present invention is not limited to the embodiments described above, and many modifications can be made. For example, the present invention may include compositions that are substantially the same as the compositions described in the embodiments (for example, a composition with the same function, method and result, or a composition with the same objects and result). Also, the present invention includes compositions in which portions not essential in the compositions described in the embodiments are replaced with others. Also, the present invention includes compositions that achieve the same functions and effects or achieve the same objects of those of the compositions described in the embodiments. Furthermore, the present invention includes compositions that include publicly known technology added to the compositions described in the embodiments.

## Claims

1. An optical element comprising:
an optical surface for light emission or light incidence;
an electrode having an opening section that is electrically connected to the optical surface; and
a mark formed by using a common resist as a mask that is used for forming the opening section.

2. An optical element comprising:
an optical surface for light emission or light incidence;
an electrode that is electrically connected to the optical surface; and
a mark containing a material identical with a material of the electrode.

3. An optical element according to claim 1, wherein the electrode is formed to surround a center section of the optical surface.

4. An optical element according to claim 1, further comprising a resin layer provided around the optical surface, wherein at least a portion of the mark is formed in a region outside of the resin layer.

5. An optical element according to claim 1, wherein the mark is used as a reference to position a line defined in a wafer in at least one of an X direction and a Y direction of the wafer when the wafer is divided along the X direction and the Y direction.

6. An optical element according to claim 5, wherein the mark includes a section that extends along the X direction and a section that extends along the Y direction.

7. An optical element according to claim 1, wherein the mark is formed in an L-shape.

8. A method for manufacturing an optical element, the method comprising the steps of:
(a) forming, above a substrate, a columnar section having an upper surface for light emission or light incidence; and
(b) forming an electrode that is electrically connected to the upper surface of the columnar section and a mark above the substrate by using a common resist as a mask.

9. A method for manufacturing an optical element according to claim 8, wherein the step (b) is conducted by using a lift-off method.

10. A method for manufacturing an optical element according to claim 8, wherein the step (b) is conducted by using an etching method.
